# EUROPÄISCHE PATENTSCHRIFT

(11) **EP 2 132 800 B1**
(45) Veröffentlichungstag und Bekanntmachung des Hinweises auf die Patenterteilung: **20.11.2013**
(21) Anmeldenummer: 08748714.6
(22) Anmeldetag: 27.03.2008
(51) Int. Cl.: H01L 51/50

(54) **ORGANISCHE STRAHLUNGSEMITTIERENDE VORRICHTUNG UND EIN HERSTELLUNGSVERFAHREN FÜR DIE VORRICHTUNG**
ORGANIC RADIATION-EMITTING DEVICE AND PRODUCTION METHOD FOR SAID DEVICE
DISPOSITIF ORGANIQUE À ÉMISSION DE RAYONNEMENTS ET PROCÉDÉ POUR LE PRODUIRE

(30) Priorität: 30.03.2007 DE 102007015468
(43) Veröffentlichungstag der Anmeldung: 16.12.2009
(73) Patentinhaber: OSRAM Opto Semiconductors GmbH, 93055 Regensburg (DE)
(72) Erfinder: VON MALM, Norwin, 93152 Nittendorf-Thumhausen (DE); KLEIN, Markus, 93105 Tegernheim (DE); BOLINK, Hendrik Jan, E-46116 Moncada (Valencia) (ES)
(74) Vertreter: Epping - Hermann - Fischer
(86) Internationale Anmeldenummer: PCT/DE2008/000539
(87) Internationale Veröffentlichungsnummer: WO 2008/119338

(56) Entgegenhaltungen:
- WO-A-2006/005172
- WO-A-2006/103909
- US-A1- 2006 232 200
- US-B1- 6 717 358

## Beschreibung

Aus der Veröffentlichung "Polymer Light-Emitting Electrochemical Cells: In Situ Formation of a Light-Emitting p-n Junction" aus dem Journal Journal of the American Chemical Society 1996, 118, S. 3922 bis 3929 sind polymere lichtemittierende Elektrochemische Zellen bekannt, die eine elektrolumineszierende Schicht aufweisen, in der gleichzeitig ein Ionenleiter vorhanden ist. Beim Anlegen eines elektrischen Feldes an zwei Elektroden die benachbart zur elektrolumineszierenden Schicht angeordnet sind, kommt es zu einer Wanderung von Ionen im elektrischen Feld und zur Aussendung von sichtbarem Licht (Elektrolumineszenz).

US 6 717 358 offenbart organische strahlungsemittierende Vorrichtungen mit dotierten Ladungstransportschichten.

Es ist eine Aufgabe von einigen Ausführungsformen der Erfindung weitere organische strahlungsemittierende Vorrichtungen bereit zu stellen.

Diese Aufgabe wird durch eine organische strahlungsemittierende Vorrichtung nach Anspruch 1 gelöst. Weitere Ausgestaltungen der strahlungsemittierenden organischen Vorrichtung, deren Verwendung sowie ein Herstellungsverfahren für die strahlungsemittierende organische Vorrichtung sind Gegenstand weiterer Ansprüche.

Eine Ausführungsform der Erfindung gibt eine organische strahlungsemittierende Vorrichtung an, die
- ein Substrat (1), und
- zumindest eine strahlungsemittierende organische Schicht (15), die zwischen einer ersten (5) und einer zweiten Elektrodenschicht (20) auf dem Substrat (1) angeordnet ist,
- wobei zwischen der ersten Elektrodenschicht (5) und der strahlungsemittierenden organischen Schicht (15) eine erste Ladungsträgertransportschicht (10) angeordnet ist, die ein erstes Ladungsträgertransportmaterial (10A) und zusätzlich einen ersten Ionenleiter umfasst, wobei der erste Ionenleiter aus einem ersten Salz (10B) und einem organischen Polymer gebildet ist, das funktionelle Gruppen aufweist, die mit den Ionen des ersten Salzes wechselwirken können, wobei bei angelegter Spannung an die erste und zweite Elektrodenschicht die Ionen des ersten Salzes weder oxidiert noch reduziert werden, umfasst.

Beim Anlegen einer Spannung an die erste und zweite Elektrodenschicht einer derartigen organischen strahlungsemittierenden Vorrichtung können von beiden Elektrodenschichten Ladungsträger, beispielsweise Defektelektronen, sogenannte "Löcher" und negative Ladungsträger, Elektronen in die strahlungsemittierende, organische Schicht injiziert werden. Dabei transportiert die erste Ladungsträgertransportschicht die aus der ersten Elektrodenschicht injizierten Ladungsträger zur strahlungsemittierenden organischen Schicht. Der Transport der von der ersten Elektrode erzeugten Ladungsträger in die organische, strahlungsemittierende Schicht kann dabei vor allem über das Ladungsträgertransportmaterial der ersten Ladungsträgertransportschicht stattfinden. Die Erfinder haben festgestellt, dass eine derartige Vorrichtung gegenüber anderen strahlungsemittierenden Vorrichtungen, deren Ladungsträgertransportschichten kein Salz umfassen, eine erhöhte Stromdichte und eine erhöhte Luminanz aufweist.

Als erstes Salz werden dabei Verbindungen verwendet, die Anionen und Kationen aufweisen, wobei zumindest ein Ion ein organisches Ion sein kann. Möglich ist es auch, dass das Salz sowohl organische Kationen als auch organische Anionen umfasst. Bevorzugt weist das erste Salz ein organisches Ion und ein anorganisches Gegenion auf. Das erste Salz kann auch metallorganische Salze umfassen.

Gemäß der Erfindung ist das erste Salz redoxstabil. Dies hat zur Folge, dass bei Anlegen einer Spannung an die erste und zweite Elektrodenschicht zwar Ladungsträger, z. B. Elektroden und Defektelektronen ("Löcher") aus diesen Elektrodenschichten in die organische, strahlungsemittierende Schicht injiziert werden, aber die Ionen des ersten Salzes selbst weder oxidiert noch reduziert werden und somit ihre ursprünglichen Oxidationszahlen beibehalten. Der Transport der Ladungsträger der ersten Elektrodenschicht erfolgt somit überwiegend bzw. ausschließlich über das Ladungsträgertransportmaterial der ersten Ladungsträgertransportschicht und nicht über die Ionen des ersten Salzes.

Gemäß der Erfindung ist das erste Salz Bestandteil eines ersten Ionenleiters.

Die Erfinder haben dabei festgestellt, dass eine Ladungsträgertransportschicht die einen Ionenleiter umfasst eine geringere Injektionsbarriere für die aus der ersten Elektrodenschicht ausgesandten Ladungsträger aufweist als eine Ladungsträgertransportschicht die keinen Ionenleiter enthält.

Bei einem Ionenleiter findet beim Anlegen einer elektrischen Spannung an der ersten und zweiten Elektrodenschicht unter dem Einfluss des elektrischen Feldes eine gerichtete Wanderung von elektrisch geladenen Ionen statt. Bei einer Wanderung von elektrisch geladenen Ionen in einem Festkörper als Ionenleiter können dabei kleinere Ionen, die auch geringere Wechselwirkungen mit dem Festkörper eingehen, wie beispielsweise Lithium über Zwischengitterplätze wandern während größere Ionen, die wie beispielsweise größere organische Ionen hauptsächlich über Gitterplätze wandern (Hopping-Leitung). Die Ionenleitung in Festkörpern ist dabei ein thermisch aktiver Prozess, bei dem die Ionen eine Potentialbarriere überwinden oder durchtunneln müssen um mittels der Hopping-Leitung Ladungen zu transportieren. Bei einer Ausführungsform der Erfindung wandern somit die Ionen des ersten Salzes im elektrischen Feld, wenn eine Spannung an die erste und zweite Elektrodenschicht angelegt wird. Im Bezug auf Ionenleitung wird vollinhaltlich Bezug genommen auf das Sprichwort "Ionenleiter" aus dem Römpp Chemielexikon 9. erweiterte Auflage Georg Thieme Verlag 1995.

Insbesondere können das erste Ladungsträgertransportmaterial und das erste Salz zusammen den ersten Ionenleiter bilden, so dass sich z. B. die Ionen des ersten Salzes in einer durch das erste Ladungsträgertransportmaterial gebildeten Matrix bei Anlegen eines elektrischen Feldes bewegen.

Gemäß der Erfindung umfasst der erste Ionenleiter ein Polymer. Dieses Polymer kann z. B. eine Matrix bilden, in der die Ionen des ersten Salzes bei Anlegen einer Spannung wandern können. Das Polymer ist ein organisches Polymer, das funktionelle Gruppen aufweist, die mit den Ionen des ersten Salzes wechselwirken können. Beispielsweise kann das Polymer Ethergruppen umfassen und somit eine Polyetherverbindung bilden. In diesem Fall können die Ethergruppen die Ionen des ersten Salzes, z. B. die Kationen koordinieren. Dabei ist es möglich, dass die Ionen in die Polymermatrix eingelagert werden und beispielsweise sogenannte Ion-Polymer-Koordinationskomplexe gebildet werden können. Derartige kristalline Ion-Polymerkomplexe können besonders geeignet sein organische polymere Ionenleiter zu bilden. Ein Beispiel für eine Polyetherverbindung ist beispielsweise Polyethylenoxid mit der allgemeinen Formel:

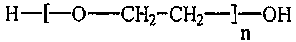

Der Polymerisationsgrad n kann dabei bis > 100000 reichen, wobei die höher molekularen festen Polymere als Polyethylenoxide und die niedermolekularen Polymere als Polyethylenglykole bezeichnet werden. Polyetherverbindungen können mit einer Vielzahl von organischen und anorganischen ersten Salzen Komplexe bilden. Innerhalb dieser Ionenleiter kann es dann bei Anlegen einer Spannung an die erste und zweite Elektrodenschicht zu einer Wanderung von Ionen mittels der Hopping-Leitung kommen.

Bei einer weiteren Ausführungsform der Erfindung umfasst der Ionenleiter neben dem Polymer ein organisches Salz als erstes Salz, das in dem Polymer eingelagert ist. Derartige Ionenleiter sind besonders geeignet als Ionenleiter in Ladungsträgertransportschichten, die ebenfalls organische Ladungsträgertransportmaterialien umfassen.

Die Erfinder gehen davon aus, dass Ionenleiter als Bestandteil einer Ladungsträgertransportschicht die Barriere für die Injektion von Ladungsträgern aus der ersten Elektrodenschicht in die erste Ladungsträgertransportschicht herabsetzen können. Dies könnte unter anderem auf eine erhöhte Akkumulation von ionischen Ladungen an der Grenzfläche zwischen der ersten Elektrodenschicht und der ersten Ladungsträgertransportschicht beim Anlegen einer Spannung zurückzuführen sein, wobei dadurch die Injektionsbarriere verringert werden könnte und somit Ladungsträger auch in der Lage sein könnten diese Injektionsbarriere zu durchtunneln. Möglich ist auch, dass eine Akkumulation von Ladungsträgern an der Grenzfläche zwischen der ersten Elektrodenschicht und der ersten Ladungsträgertransportschicht die Austrittarbeit für die Ladungsträger aus der ersten Elektrodenschicht erniedrigt und so eine erhöhte Stromdichte und Luminanz für die organische strahlungsemittierende Vorrichtung resultiert. In dem Fall, dass die erste Elektrodenschicht als Kathode geschaltet ist, kann somit das Fermi-Niveau der ersten Elektrodenschicht durch das Vorhandensein des ersten Salzes angehoben werden, was eine Reduzierung der Austrittsarbeit für die Elektronen zur Folge haben kann.

Bei einer weiteren Ausführungsform der Erfindung ist das erste Salz so gewählt, dass sowohl die Anionen wie auch die Kationen des Salzes im elektrischen Feld beweglich sind. Hierbei kann das Salz so gewählt sein, dass entweder das Kation oder das Anion deutlich schneller wandert, als das jeweilige Gegenion. Es ist aber auch eine Ausführungsform möglich, in der das Kation und Anion eine vergleichbare Wanderungsgeschwindigkeit im elektrischen Feld besitzen.

Durch die Wanderung von Ionen einer Ladung in der Ladungsträgertransportschicht in Richtung der beispielsweise angrenzenden Elektrode, ist eine Ladungsverdichtung entsprechend der Ladung der Ionen am Grenzbereich zwischen Ladungstransportschicht und Elektrodenschicht möglich.

Es kann im Grenzbereich zwischen Elektrodenschicht und Ladungsträgertransportschicht zur Ausbildung einer "Schottky-Barriere" kommen. Diese wird im Gegensatz zum pn-Übergang in einer herkömmlichen Halbleiterdiode nicht durch den Halbleiter-Halbleiter-Übergang gebildet, sondern in der Regel durch einen Halbleiter-Metall-Übergang.

Diese "Schottky-Barriere" hat zur Folge, dass die Austrittsarbeit der Ladungsträger aus der Elektrode in die Ladungsträgertransportschicht herabgesetzt wird.

Weiterhin kann das Polymer redoxstabil sein und somit beim Anlegen einer Spannung an die erste und zweite Elektrodenschicht weder oxidiert noch reduziert werden.

Beispielsweise kann als Polymer Poly(ethylenoxid) (PEO) und als erstes Salz Lithiumtrifluoroalkylsulfonat, z. B. Li⁺ F₃CSO₄⁻ für den ersten Ionenleiter verwendet werden. Weitere Beispiele sind Komplexe von PEO mit LiAsF₆, KSCN, NaBPh₄ oder ZnCl₂.

Weiterhin ist es auch möglich Polyelektrolyte als Ionenleiter zu verwenden. Polyelektrolyte sind beispielsweise Polymere mit ionisch dissoziierbaren Gruppen die Bestandteil oder ein Substituent der Polymerkette sein können. Dabei sind vor allen Dingen die Gegenionen zu den polymeren Ionen, die zum Ladungsausgleich vorhanden sind, dazu geeignet in der Polyelektrolytmatrix mittels des Hopping-Mechanismus Ladungen zu transportieren. Dabei ist es möglich, dass der polymere Bestandteil der Polyelektrolyte beispielsweise ein Polymeranion ist und dann zum Ladungsausgleich Kationen in die anionische Polymermatrix eingelagert sind. In diesem Falle können dann besonders gut die Kationen bei Anlegen einer Spannung mittels der Hopping-Leitung in der Polyelektrolytmatrix wandern. Weiterhin ist es auch möglich kationisch geladene polymere Bestandteile zu verwenden, die als Gegenionen Anionen aufweisen die in der Polymermatrix eingelagert sind. In diesem Fall können dann vor allen Dingen bei Anlegen eines elektrischen Feldes an die erste und zweite Elektrodenschicht die Anionen mittels des Hopping-Mechanismus in der kationisch geladenen Polymermatrix wandern.

Mögliche Beispiele für Polyelektrolyte sind beispielsweise Poly(Natriumstyrolsulfonat) mit der folgenden allgemeinen Formel:

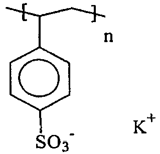

Wobei der Polymerisationsgrad n so gewählt werden kann, dass die Molmasse größer 1 000000 g/mol beträgt und K⁺ für das Gegenkation steht.

Möglich ist auch die Verwendung von Polyacrylaten mit z. B. der folgenden allgemeinen Formel:

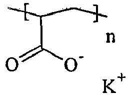

In beiden Fällen liegt eine anionische Polymermatrix vor, in die Kationen zum Ladungsausgleich eingelagert sind.

Weiterhin können auch noch Polyelektrolyte als Ionenleiter zum Einsatz kommen die nur eine geringe Anzahl von ionischen Gruppen aufweisen und sogenannte Ionomere sind. Beispielsweise können sulfonierte Tetrafluorethylen-Copolymere, die zum Beispiel unter dem Markennamen Nafion® vertrieben werden, eingesetzt werden. Bei derartigen Polymeren bilden die Sulfonate ionisch dissoziierbare Gruppen, so dass eine negativ geladene Polymermatrix vorliegt in die Kationen zum Ladungsausgleich eingelagert sind. Mögliche Kationen können dabei beispielsweise Alkali- oder Erdalkalimetallkationen sein, z. B. Lithium, Magnesium oder Natrium.

In einer weiteren Ausführungsform der Erfindung umfasst die erste Ladungsträgertransportschicht ein erstes organisches Ladungsträgertransportmaterial. Das Ladungsträgertransportmaterial ist dabei aufgrund seiner chemischen Struktur geeignet Ladungsträger, negative Ladungen wie Elektronen oder positive Ladungen wie Defektelektronen oder Löcher zu transportieren.

Ladungsträgertransportmaterialien zum Transport von positiven Ladungsträgern, sogenannte Lochtransportmaterialien können beispielsweise Elektronendonorgruppen wie beispielsweise Amine aufweisen. Mögliche Beispiele für Lochtransportmaterialien sind Arylamine, wie z. B. 1,1-Bis[4-(4-methylstyryl)phenyl-4-tolylaminophenyl]cyclohexan, 5'[4-[Bis(4-ethylphenyl(amino]-N,N,N',N'-tetrakis(4-ethylphenyl)1,1',3'1"-terphenyl]-4,4"-diamin (EFTP), N,N'-Bis(1-naphtalen)-N,N'-diphenyl-4,4'-penylamin (NPPDA), N,N,N',N'-Tetrakis(m-methylphenyl)-1,3-diaminobenzol (TAPC), Bis(ditolylamostryl)benzol (TASB), N,N-Diphenyl-N,N'-bis(3-methylphenyl)-(1,1'biphenyl)-4,4'-diamin (TPD), N,N',N",N"'-Tetrakis(4-methylphenyl)-1,1'-biphenyl)-4,4'-diamin (TTB), Triphenylamin (TPA) und Tri-p-tolylamin (TTA). Weitere Beispiele für Lochtransportmaterialien sind Enamine, Hydrazone, Oxadiazole und Oxazole, Phthalocyanine, Pyrazoline und Poly(N-vinylcarbazol) (PVK).

Verwendet werden können auch polymere Lochtransportmaterialien wie beispielsweise Polyethylendioxythiophen (PEDOT) mit Polystyrolsulfonsäure (PPS).

Ladungsträgertransportmaterialien zum Transport von negativen Ladungsträgern, sogenannte Elektronentransportmaterialien können beispielsweise Elektronenakzeptorgruppen, sog. elektronenziehende Gruppen aufweisen wie zum Beispiel Anthrachinone, Diphenochinone, Indane, 2,4,7-Trinitro-9-fluorenon und dessen Mischungen mit PVK, sowie Sulfone.

Es ist auch möglich Mischungen verschiedener Ladungsträgertransportmaterialien in einer Ladungsträgertransportschicht zu verwenden.

In dem Fall, dass die erste Elektrodenschicht als Anode geschaltet ist, umfasst das erste Ladungsträgertransportmaterial der ersten Ladungsträgertransportschicht ein Lochtransportmaterial, im Fall einer Schaltung als Kathode umfasst das erste Ladungsträgertransportmaterial der ersten Ladungsträgertransportschicht ein Elektronentransportmaterial.

Aufgrund des Vorhandenseins des ersten Salzes in der Ladungsträgertransportschicht kann das Dotieren des ersten Ladungsträgertransportmaterials mit p- oder n-Dotierstoffen je nachdem ob es sich um ein Lochtransportmaterial oder ein Elektronentransportmaterial handelt, entfallen. Diese Dotierstoffe sind häufig chemisch reaktiv und können daher die Lebensdauer der Vorrichtung negativ beeinflussen. Im Gegensatz dazu ist das erste Salz bevorzugt chemisch inert und wie auch oben bereits geschildert, redoxstabil.

Bei weiteren Ausführungsbeispielen der Erfindung bei der die erste Ladungsträgertransportschicht ein erstes Ladungsträgertransportmaterial und einen ersten Ionenleiter umfassend das erstes Salz aufweist, kann in dem Fall dass die erste Elektrodenschicht als Anode geschaltet ist das erste Salz Anionen aufweisen, die eine höhere Beweglichkeit in der Ladungsträgertransportschicht aufweisen als die Kationen des ersten Salzes. Dabei kommt es dann bei Anlegen einer Spannung an der Grenzfläche zwischen der Anode und der Lochtransportschicht zur Akkumulation von Anionen. Aufgrund ihrer geringeren Beweglichkeit findet aber die nicht vorteilhafte Wanderung der Kationen zur Kathode, die eventuell durch die strahlungsemittierende organische Schicht stattfinden würde nicht, oder nur im untergeordneten Maße statt. In der Regel gehen die Anionen, die eine erhöhte Beweglichkeit aufweisen nur eine geringe Wechselwirkung mit der Lochtransportschicht ein und sind auch häufig kleiner als die nicht so beweglichen Kationen. Ein Beispiel für ein solches erstes Salz sind Tetraalkylammonium-Salze mit anorganischen kleinen Anionen wie PF₆⁻ oder AsF₆⁻, die z. B. mit Arylaminen als ersten Lochtransportmaterialien verwendet werden können.

Analog dazu kann das erste Salz auch Kationen aufweisen, die eine höhere Beweglichkeit in der ersten Ladungsträgertransportschicht aufweisen als die Anionen, wenn die erste Elektrodenschicht als Kathode geschaltet ist. In diesem Fall kann es dann bei Anlegen einer Spannung zu einer Akkumulation von Kationen an der Grenzfläche zwischen der Kathode und der Elektronentransportschicht kommen, wobei umgekehrt die Wanderung von Anionen nicht, oder nur im stark eingeschränkten Maße stattfindet. Beispiele für derartige erste Salze sind Alkylsulfonate (z. B. Trifluoroalkylsulfonate) mit kleinen Kationen, wie z. B. Lithium.

Gemäß einer weiteren Ausführungsform der Erfindung kann das Ladungsträgertransportmaterial auch gleichzeitig die Funktion eines ersten Ionenleiters innehaben.

Die strahlungsemittierende organische Schicht kann Materialien enthalten, die ausgewählt sind aus elektrolumineszierenden niedermolekularen ("small molecules") Verbindungen und elektrolumineszierenden Polymeren, so dass die strahlungsemittierende Vorrichtung insbesondere eine organische, lichtemittierende Vorrichtung (OLED) sein kann. Bei OLEDs kommt es infolge einer Rekombination von Elektroden und Löchern in der strahlungsemittierenden organischen Schicht zur Aussendung von Strahlung (Elektrolumineszenz).

Beispiele für elektrolumineszierende Polymere sind Poly(1,4-phenylenvinylen) (PPV) und dessen Abkömmlinge, Polychinoline und deren Abkömmlinge, Co-Polymere of Polychinolin mit p-Phenylenen, Poly(p-phenylee-2,6-benzobisthiazol), Poly(p-phenylen-2,6-benzobisoxazol), Polyp-phenylen-2,6-benzimidazol) und dessen Derivate, Poly(arylens) mit Arylresten wie Naphthalin, Anthracen, Furylen, Thienylen, Oxadiazol, Polyp-phenylene und deren Derivate wie z. B. Poly(9,9-dialkyl fluorene).

Niedermolekulare, elektrolumineszierende Verbindungen sind z. B. Tris(8-hydroxyquinolinato) Aluminium (Alq₃) ; 1,3-bis(N,N-dimethylaminophenyl)-1,3,4-oxidazol (OXD-8); Oxo-bis(2-methyl-8-quinolinato)Aluminium; Bis(2-methyl-8-hydroxyquinolinato) Aluminium; Bis(hydroxybenzoquinolinato) Beryllium (BeQ₂); Bis(diphenylvinyl)biphenylen (DPVBI) und Arylamin-substituierte Distyrylarylene (DSA Amine).

Weiterhin können sowohl zwischen der Anode als auch der Kathode der strahlungsemittierenden Vorrichtungen Loch- bzw. Elektronentransportschichten als Ladungsträgertransportschichten vorhanden sein. Dann ist ebenfalls zwischen der zweiten Elektrodenschicht und der strahlungsemittierenden organischen Schicht eine zweite Ladungsträgertransportschicht vorhanden. Diese weist ebenfalls ein zweites Salz auf, das auch Bestandteil eines zweiten Ionenleiters sein kann. Dieser Ionenleiter kann wieder analog zu dem bereits oben beschriebenen ersten Ionenleiter aufgebaut sein.

Die von der strahlungsemittierenden organischen Vorrichtung emittierte Strahlung kann im ultravioletten bis infraroten Wellenlängenbereich liegen, bevorzugt im sichtbaren Wellenlängenbereich von etwa 400 nm bis 800 nm.

Die strahlungsemittierende organische Vorrichtung kann z. B. als sogenannte "bottom-emitting" Vorrichtung ausgeführt sein, die die erzeugte Strahlung durch das Substrat nach außen abstrahlt. In dem Fall, dass die erste Elektrodenschicht auf dem Substrat angeordnet ist, wird dann die in der strahlungsemittierenden organischen Schicht erzeugte Strahlung durch die erste Ladungsträgertransportschicht, die erste Elektrodenschicht und dann das Substrat nach außen gekoppelt. Die erste Ladungsträgertransportschicht, die erste Elektrodenschicht und das Substrat sind dann transparent für die emittierte elektromagnetische Strahlung.

Alternativ oder zusätzlich kann die strahlungsemittierende organische Vorrichtung auch als "top-emitting" Vorrichtung ausgeführt sein, bei der die emittierte Strahlung durch die weiter von dem Substrat entfernte Elektrodenschicht und eine über der Schichtanordnung aus Elektrodenschichten, der strahlungsemittierenden organischen Schicht und der Ladungsträgertransportschicht befindliche Verkapselung abgestrahlt wird. In diesem Fall sind die Elektrodenschicht, durch die die Strahlung nach außen gekoppelt wird und die Verkapselung transparent für die emittierte Strahlung.

Die strahlungsemittierenden Vorrichtungen können beispielsweise für Beleuchtungsanwendungen in Beleuchtungsvorrichtungen eingesetzt werden. Möglich ist auch eine Verwendung in Anzeigen-Vorrichtungen wie z. B. Diplay-Vorrichtungen.

Gegenstand einer weiteren Ausführungsform der Erfindung ist auch ein Verfahren zur Herstellung der strahlungsemittierenden Vorrichtung mit den Verfahrensschritten:
A) Bereitstellen eines Substrats,
B) Erzeugen einer Schichtanordnung umfassend eine strahlungsemittierende organische Schicht, eine erste Elektrodenschicht, eine erste Ladungsträgertransportschicht und zweite Elektrodenschicht auf dem Substrat, wobei die erste Ladungsträgertransportschicht zwischen der ersten Elektrodenschicht und der strahlungsemittierenden organischen Schicht erzeugt wird und ein erstes Ladungsträgertransportmaterial und ein erstes Salz umfasst.

Der Verfahrensschritt B) kann dabei die folgenden Teilverfahrensschritte umfassen für den Fall, dass die erste Elektrodenschicht auf dem Substrat erzeugt wird:
B1) Erzeugen der ersten Elektrodenschicht auf dem Substrat,
B2) Erzeugen der ersten Ladungsträgertransportschicht auf der ersten Elektrodenschicht,
B3) Erzeugen der strahlungsemittierenden organischen Schicht auf der ersten Ladungsträgertransportschicht,
B4) Erzeugen der zweiten Elektrodenschicht auf der strahlungsemittierenden organischen Schicht.

In Verfahrensschritt B2) kann eine Mischung des ersten Ladungsträgertransportmaterials und des ersten Ionenleiters aufgebracht werden. In dem Fall, dass sowohl der erste Ionenleiter polymere Bestandteile aufweist als auch das erste Ladungsträgertransportmaterial können beide mittels naßchemischer Verfahren z. B. auch zusammen mit dem ersten Salz aus Lösung aufgebracht werden. Die Aufbringverfahren können z. B. Druckverfahren, spin coating oder dip coating sein. Die Druckverfahren können z. B. Tintenstrahldruckverfahren, Walzendruckverfahren oder Siebdruckverfahren sein.

Weiterhin können im Verfahrensschritt B2) auch niedermolekulare Materialien als Ladungsträgertransportmaterialien und als Bestandteile des ersten Ionenleiters verwendet werden. In diesem Fall können diese Bestandteile auch aus der Gasphase z. B. zusammen mit dem ersten Salz aufgebracht werden.

In den beiden oben genannten Fällen für den Verfahrensschritt B2) ist es aber auch möglich zuerst eine Schicht aus den Ladungsträgertransportmaterialien und den polymeren oder niedermolekularen Bestandteilen des ersten Ionenleiters zu erzeugen und dann erst das erste Salz aufzubringen wobei dieses dann in die bereits vorhandene Schicht eindiffundieren kann.

Alternativ kann auch zuerst die zweite Elektrodenschicht auf dem Substrat erzeugt werden und dann der Reihe nach die funktionelle Schichtanordnung über dem Substrat aufgebaut werden, wobei der Verfahrensschritt B) dann die folgenden Teilverfahrensschritte umfasst:
B1) Erzeugen der zweiten Elektrodenschicht auf dem Substrat,
B2) Erzeugen der der strahlungsemittierenden organischen Schicht auf der zweiten Elektrodenschicht,
B3) Erzeugen der ersten Ladungsträgertransportschicht auf der strahlungsemittierenden organischen Schicht,
B4) Erzeugen der ersten Elektrodenschicht auf der ersten Ladungsträgertransportschicht.

Bei einer derartigen Variante sind für den Verfahrensschritt B3) auch die bereits oben für den analogen Teilverfahrensschritt B2), der Erzeugung der ersten Ladungsträgertransportschicht, genannten möglichen Ausgestaltungen denkbar.

Im folgenden sollen einige Ausführungsformen der Erfindung anhand von Figuren und Ausführungsbeispielen näher erläutert werden. Gleiche Bezugszeichen bezeichnen dabei in allen Figuren gleiche Elemente:
Figur 1 zeigt im Querschnitt eine Variante einer erfindungsgemäßen Vorrichtung mit einer ersten Ladungsträgertransportschicht.
In Figur 2 ist im Querschnitt eine weitere Ausführungsform einer erfindungemäßen Vorrichtung mit einer ersten und einer zweiten Ladungsträgertransportschicht gezeigt.
Figur 3 zeigt eine Vorrichtung mit einer Verkapselung.
Figur 4 zeigt ein Diagramm in dem die Stromdichte und Luminanz von verschiedenen Vorrichtungen dargestellt sind.

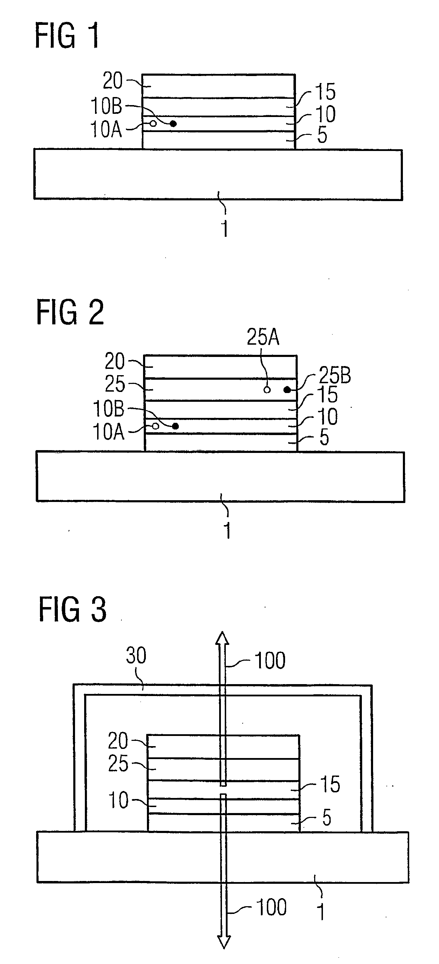

Figur 1 zeigt eine Variante einer erfindungemäßen strahlungsemittierenden Vorrichtung bei der auf einen Substrat 1 eine erste Elektrodenschicht 5, eine erste Ladungsträgertransportschicht 10, eine strahlungsemittierende organische Schicht 15 und eine zweite Elektrodenschicht 20 angeordnet sind. Schematisch ist angedeutet, dass die erste Ladungsträgertransportschicht 10 ein erstes Ladungsträgertransportmaterial 10A und ein erstes Salz 10B aufweist. Aufgrund des Vorhandenseins des ersten Salzes 10B weist eine derartige Vorrichtung eine erhöhte Luminanz und Stromdichte in den organischen Funktionsschichten auf.

In Figur 2 ist eine weitere Variante einer erfindungemäßen strahlungsemittierenden Vorrichtung gezeigt, bei der neben der ersten Ladungsträgertransportschicht 10 noch eine zweite Ladungsträgertransportschicht 25 vorhanden ist. Diese umfasst dabei, schematisch gezeigt, ein zweites Ladungsträgertransportmaterial 25A und ein zweites Salz 25B. Wegen der ersten Ladungsträgertransportschicht 10 und der zweiten Ladungsträgertransportschicht 25 ist eine erleichterte Injektion von Ladungsträgern aus beiden Elektrodenschichten in die strahlungsemittierende organische Schicht 15 möglich.

Figur 3 zeigt eine weitere Variante einer erfindungemäßen strahlungsemittierenden Vorrichtung mit einer Verkapselung 30 über der organischen funktionellen Schichtanordnung. Durch die beiden Pfeile 100 ist angedeutet, dass die emittierte Strahlung sowohl durch die transparente Verkapselung 30 hindurch als auch durch das transparente Substrat 1 hindurch aus der Vorrichtung ausgekoppelt werden kann.

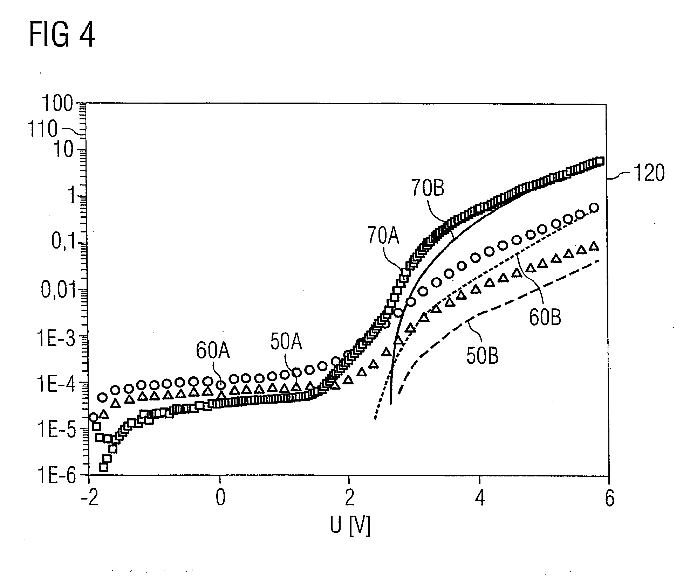

In Figur 4 ist ein Diagramm dargestellt, das die Luminanzen und Stromdichten verschiedener strahlungsemittierender Vorrichtungen in Abhängigkeit von der Menge des ersten Salzes in einer Polyarylamin-Lochtransportschicht angibt. Die mit 110 bezeichnete Achse gibt die Stromdichte J in A/m² an und die mit 120 bezeichnete Achse die Luminanz in Cd/m². Auf der unteren Achse ist die angelegte Spannung in V angegeben. Die mit den A-Nummern bezeichneten Kurven zeigen die Stromdichten und die mit den B-Nummern versehenen Kurven, die jeweiligen dazugehörigen Luminanzen. Es ist zu erkennen, dass eine Vorrichtung, bei der kein erstes Salz in der Lochtransportschicht vorhanden ist (mit 50A bezeichnete Kurve für Stromdichte und mit 50B bezeichnete Kurve für Luminanz) eine geringere Stromdichte und Luminanz aufweist, als eine Vorrichtung, die 2 Gewichts% eines ersten Salzes in der Lochtransportschicht aufweist (mit 60A bezeichnete Kurve für Stromdichte und mit 60B bezeichnete Kurve für Luminanz). Die Vorrichtung mit 2 Gewichts% des ersten Salzes wiederum zeigt eine geringere Stromdichte und Luminanz als eine OLED-Vorrichtung mit 5 Gewichts% Salz (mit 70A bezeichnete Kurve für Stromdichte und mit 70B bezeichnete Kurve für Luminanz). Somit ist deutlich zu erkennen, dass mit zunehmender Salzkonzentration die Stromdichte und Luminanz zunehmen.

### Ausführungsbeispiel:

Indium-Zinn-Oxid (ITO) beschichtete Glasplatten werden als Substrate mit ersten Elektrodenschichten verwendet und gereinigt. Danach wird ein Polyarylamin, pTPD das unter der Bezeichnung ADS254BE von American Dye Source erhältlich ist in Chlorbenzol gelöst. In einem typischen Beispiel werden 40 mg pTPD in 2 ml Chlorbenzol gelöst und zu dieser Lösung 0,113 mg eines organischen Salzes Tetrabutylammonium-hexafluorophosphat, gelöst in Chlorbenzol gegeben. Die Lösung wird dann durch ein 0,45 µm PTFE Filter gefiltert. Mit dieser Mischung wird dann mittels spin-coating bei 2000 Umdrehungen/min eine dünne Schicht auf dem ITO-Glassubstrat aufgebracht. Die Dicke der aufgebrachten Schichten wird mit Hilfe eines Ambios XP1 Profilometers bestimmt. Danach wird eine Schicht eines elektrolumineszierenden Polymers, z. B. ein Polyfluoren-Derivat, das unter der Bezeichnung ADS136BE von American Dye Source erhältlich ist, mittels Spin coatings einer Lösung des Polymers in Toluol aufgebracht. Aufgrund der Unlöslichkeit der pTPD-Schicht in Toluol kommt es zu keiner Vermischung der Lochtransportschicht mit der elektrolumineszierenden Schicht. Darauf wurde eine Kathode bestehend aus 5 nm Ba und 80 nm Silber aufgebracht.

Die Stromdichte und Luminanz im Verhältnis zur Spannung wird mittels eines Keithley 2400 Strommeters und einer Photodiode, die an ein Keithley 6485 Picoampmeter angeschlossen ist, bestimmt, wobei der Photostrom mittels einer Minolta LS100 kalibriert wird. Ein Avantes Luminanz-Spektrometer wird verwendet, um die EL-Spektren der OLEDs zu bestimmen.

Verschiedene Mengen des organischen Salzes werden bei der Herstellung der Lochtransportschicht für verschiedene OLEDs verwendet und die jeweiligen Stromdichten und Luminanzen bestimmt, wobei das in Fig. 4 gezeigte Diagramm resultiert.

## Patentansprüche

1. Organische strahlungsemittierende Vorrichtung, umfassend
- ein Substrat (1), und
- zumindest eine strahlungsemittierende organische Schicht (15), die zwischen einer ersten (5) und einer zweiten Elektrodenschicht (20) auf dem Substrat (1) angeordnet ist,
- wobei zwischen der ersten Elektrodenschicht (5) und der strahlungsemittierenden organischen Schicht (15) eine erste Ladungsträgertransportschicht (10) angeordnet ist, die ein erstes Ladungsträgertransportmaterial (10A) und zusätzlich einen ersten Ionenleiter umfasst, wobei der erste Ionenleiter aus einem ersten Salz (10B) und einem organischen Polymer gebildet ist, das funktionelle Gruppen aufweist, die mit den Ionen des ersten Salzes wechselwirken können
**dadurch gekennzeichnet, dass** bei angelegter Spannung an die erste und zweite Elektrodenschicht die Ionen des ersten Salzes weder oxidiert noch reduziert werden.

2. Organische strahlungsemittierende Vorrichtung nach dem vorhergehenden Anspruch,
- bei der das Salz ein organisches Salz umfasst.

3. Organische strahlungsemittierende Vorrichtung nach einem der vorhergehenden Ansprüche,
- bei der das Polymer eine Polyether-Verbindung umfasst.

4. Organische strahlungsemittierende Vorrichtung nach dem vorhergehenden Anspruch,
- bei der die Polyether-Verbindung Polyethylenoxid oder ein Polyethylenglykol ist.

5. Organische strahlungsemittierende Vorrichtung nach einem der vorhergehenden Ansprüche,
- bei der der erste Ionenleiter einen Komplex des Polymers mit dem Salz umfasst.

6. Organische strahlungsemittierende Vorrichtung nach einem der vorhergehenden Ansprüche,
- bei der das Polymer bei angelegter Spannung an die erste und zweite Elektrodenschicht weder oxidiert noch reduziert wird.

7. Organische strahlungsemittierende Vorrichtung nach einem der vorhergehenden Ansprüche,
- bei der der erste Ionenleiter als Polymer Poly(ethylenoxid) und als Salz Lithiumtrifluoroalkylsulfonat umfasst.

8. Organische strahlungsemittierende Vorrichtung nach einem der Ansprüche 1 bis 6,
- bei der der erste Ionenleiter als Polymer Poly(ethylenoxid) und als Salz LiAsF6, KSCN, NaBPh4 oder ZnCl2 umfasst.

9. Organische strahlungsemittierende Vorrichtung nach einem der vorhergehenden Ansprüche,
- bei der die erste Elektrode eine Anode ist und
- bei der die erste Ladungsträgertransportschicht ein erstes Salz umfasst, bei dem die Anionen eine höhere Beweglichkeit in der ersten Ladungsträgertransportschicht aufweisen als die Kationen.

10. Organische strahlungsemittierende Vorrichtung nach einem der vorhergehenden Ansprüche,
bei der das Salz (10B) so gewählt ist, dass beim Anlegen eines elektrischen Feldes sowohl die Anionen wie auch die Kationen des Salzes (10B) in der ersten Ladungsträgertransportschicht (10) beweglich sind.

11. Organische strahlungsemittierende Vorrichtung nach einem der vorhergehenden Ansprüche,
- bei der durch die Wanderung der Ionen des Salzes (10B) eine Schottky-Barriere ausgebildet wird.

12. Verfahren zur Herstellung einer organischen strahlungsemittierenden Vorrichtung nach einem der vorhergehenden Ansprüche 1 bis 11 mit den Verfahrensschritten:
A) Bereitstellen eines Substrats,
B) Erzeugen einer Schichtanordnung umfassend eine strahlungsemittierende organische Schicht, eine erste Elektrodenschicht, eine erste Ladungsträgertransportschicht und zweite Elektrodenschicht auf dem Substrat,
wobei die erste Ladungsträgertransportschicht zwischen der ersten Elektrodenschicht und der strahlungsemittierenden organischen Schicht erzeugt wird und ein erstes Ladungsträgertransportmaterial und zusätzlich einen ersten Ionenleiter umfasst, wobei der erste Ionenleiter aus einem ersten Salz und einem Polymer gebildet ist, das funktionelle Gruppen aufweist, die mit den Ionen des ersten Salzes wechselwirken können.

13. Verfahren nach dem vorhergehenden Anspruch,
- bei dem der Verfahrensschritt B) folgende Teilschritte umfasst:
B1) Erzeugen der ersten Elektrodenschicht auf dem Substrat,
B2) Erzeugen der ersten Ladungsträgertransportschicht auf der ersten Elektrodenschicht,
B3) Erzeugen der strahlungsemittierenden organischen Schicht auf der ersten Ladungsträgertransportschicht,
B4) Erzeugen der zweiten Elektrodenschicht auf der strahlungsemittierenden organischen Schicht.

## Claims

1. Organic radiation-emitting device, comprising
- a substrate (1), and
- at least one radiation-emitting organic layer (15) arranged between a first (5) and a second electrode layer (20) on the substrate (1),
- wherein a first charge carrier transport layer (10) is arranged between the first electrode layer (5) and the radiation-emitting organic layer (15), said first charge carrier transport layer comprising a first charge carrier transport material (10A) and additionally a first ion conductor, wherein the first ion conductor is formed from a first salt (10B) and an organic polymer comprising functional groups which can interact with the ions of the first salt,
**characterized in that** the ions of the first salt are neither oxidized nor reduced when voltage is applied to the first and second electrode layers.

2. Organic radiation-emitting device according to the preceding claim,
- wherein the salt comprises an organic salt.

3. Organic radiation-emitting device according to either of the preceding claims,
- wherein the polymer comprises a polyether compound.

4. Organic radiation-emitting device according to the preceding claim,
- wherein the polyether compound is polyethylene oxide or a polyethylene glycol.

5. Organic radiation-emitting device according to any of the preceding claims,
- wherein the first ion conductor comprises a complex of the polymer with the salt.

6. Organic radiation-emitting device according to any of the preceding claims,
- wherein the polymer is neither oxidized nor reduced when voltage is applied to the first and second electrode layers.

7. Organic radiation-emitting device according to any of the preceding claims,
- wherein the first ion conductor comprises poly(ethylene oxide) as polymer and lithium trifluoroalkylsulphonate as salt.

8. Organic radiation-emitting device according to any of Claims 1 to 6,
- wherein the first ion conductor comprises poly(ethylene oxide) as polymer and LiAsF₆, KSCN, NaBPh₄ or ZnCl₂ as salt.

9. Organic radiation-emitting device according to any of the preceding claims,
- wherein the first electrode is an anode, and
- wherein the first charge carrier transport layer comprises a first salt in the case of which the anions have a higher mobility in the first charge carrier transport layer than the cations.

10. Organic radiation-emitting device according to any of the preceding claims,
wherein the salt (10B) is chosen such that when an electric field is applied, both the anions and the cations of the salt (10B) are mobile in the first charge carrier transport layer (10).

11. Organic radiation-emitting device according to any of the preceding claims,
- wherein a Schottky barrier is formed by the migration of the ions of the salt (10B).

12. Method for producing an organic radiation-emitting device according to any of the preceding claims 1 to 11 comprising the following method steps:
A) Providing a substrate,
B) Producing a layer arrangement comprising a radiation-emitting organic layer, a first electrode layer, a first charge carrier transport layer and a second electrode layer on the substrate,
wherein the first charge carrier transport layer is produced between the first electrode layer and the radiation-emitting organic layer and comprises a first charge carrier transport material and additionally a first ion conductor, wherein the first ion conductor is formed from a first salt and a polymer comprising functional groups which can interact with the ions of the first salt.

13. Method according to the preceding claim,
- wherein method step B) comprises the following substeps:
B1) Producing the first electrode layer on the substrate,
B2) Producing the first charge carrier transport layer on the first electrode layer,
B3) Producing the radiation-emitting organic layer on the first charge carrier transport layer,
B4) Producing the second electrode layer on the radiation-emitting organic layer.

## Revendications

1. Dispositif organique émettant un rayonnement, comprenant :
un substrat (1) et
au moins une couche organique (15) émettant un rayonnement, disposée sur le substrat (1) entre une première couche d'électrode (5) et une deuxième couche d'électrode (20),
une première couche (10) de transport de porteurs de charge disposée entre la première couche d'électrode (5) et la couche organique (15) émettant un rayonnement et comportant un premier matériau (10A) de transport de porteurs de charge et
un premier conducteur ionique, le premier conducteur ionique étant formé d'un premier sel (10B) et d'un polymère organique qui présente des groupes fonctionnels pouvant interagir avec les ions du premier sel,
**caractérisé en ce que**
les ions du premier sel ne sont ni oxydés ni réduits lorsqu'une tension est appliquée sur la première et la deuxième couche d'électrode.

2. Dispositif organique émettant un rayonnement selon la revendication précédente, dans lequel le sel comprend un sel organique.

3. Dispositif organique émettant un rayonnement selon l'une des revendications précédentes, dans lequel le polymère comprend un composé polyéther.

4. Dispositif organique émettant un rayonnement selon la revendication précédente, dans lequel le composé polyéther est le poly(oxyde d'éthylène) ou un polyéthylène glycol.

5. Dispositif organique émettant un rayonnement selon l'une des revendications précédentes, dans lequel le premier conducteur ionique comprend un complexe du polymère avec le sel.

6. Dispositif organique émettant un rayonnement selon l'une des revendications précédentes, dans lequel le polymère n'est ni oxydé ni réduit lorsqu'une tension est appliquée sur la première et la deuxième couche d'électrode.

7. Dispositif organique émettant un rayonnement selon l'une des revendications précédentes, dans lequel le premier conducteur ionique comporte comme polymère le poly(oxyde d'éthylène) et comme sel le trifluoroalkylsulfonate de lithium.

8. Dispositif organique émettant un rayonnement selon l'une des revendications 1 à 6, dans lequel le premier conducteur ionique comporte comme polymère le poly(oxyde d'éthylène) et comme sel le LiAsF₆, le KSCN, le NaBPh₄ ou le ZnCl₂.

9. Dispositif organique émettant un rayonnement selon l'une des revendications précédentes, dans lequel la première électrode est une anode et dans lequel la première couche de transport de porteurs de charge comporte un premier sel dont les anions présentent une mobilité plus grande dans la couche de transport de porteurs de charge que les cations.

10. Dispositif organique émettant un rayonnement selon l'une des revendications précédentes, dans lequel le sel (10B) est sélectionné de telle sorte que lorsqu'un champ électrique est appliqué, tant les anions que les cations du sel (10B) peuvent se déplacer dans la première couche (10) de transport de porteurs de charge.

11. Dispositif organique émettant un rayonnement selon l'une des revendications précédentes, dans lequel le déplacement des ions du sel (10B) forme une barrière de Schottky.

12. Procédé de fabrication d'un dispositif organique émettant un rayonnement selon les revendications 1 à 11 qui précèdent, le procédé présentant les étapes qui consistent à :
A) préparer un substrat,
B) former sur le substrat un ensemble de couches comprenant une couche organique émettant un rayonnement, une première couche d'électrode, une première couche de transport de porteurs de charge et une deuxième couche d'électrode, la première couche de transport de porteurs de charge étant formée entre la première couche d'électrode et la couche organique émettant un rayonnement et comportant un premier matériau de transport de porteurs de charge et de plus un premier conducteur ionique, le premier conducteur ionique étant formé d'un premier sel et d'un polymère qui présente des groupes fonctionnels aptes à interagir avec les ions du premier sel.

13. Procédé selon la revendication précédente, dans lequel l'étape B) du procédé comporte les étapes partielles suivantes :
B1) formation de la première couche d'électrode sur le substrat,
B2) formation de la première couche de transport de porteurs de charge sur la première couche d'électrode,
B3) formation de la couche organique émettant un rayonnement sur la première couche de transport de porteurs de charge et
B4) formation de la deuxième couche d'électrode sur la couche organique émettant un rayonnement.
